# EUROPÄISCHE PATENTSCHRIFT

(11) **EP 1 558 844 B1**
(45) Veröffentlichungstag und Bekanntmachung des Hinweises auf die Patenterteilung: **29.12.2010**
(21) Anmeldenummer: 03770911.0
(22) Anmeldetag: 14.10.2003
(51) Int. Cl.: F02M 59/46, F02M 51/06, F02M 61/16, H01L 41/083, H01L 41/047, H01L 41/053, F02M 51/00

(54) **PIEZOAKTORKONTAKTIERUNG FÜR EINSPRITZVENTIL**
PIEZO-ELECTRIC ACTUATOR CONTACTING FOR AN INJECTION VALVE
CONTACT D'ACTIONNEUR PIEZO-ELECTRIQUE POUR SOUPAPE D'INJECTION

(30) Priorität: 04.11.2002 DE 10251225
(43) Veröffentlichungstag der Anmeldung: 03.08.2005
(73) Patentinhaber: Continental Automotive GmbH, 30165 Hannover (DE)
(72) Erfinder: UNRUH, Marcus, 93197 Zeitlarn (DE)
(86) Internationale Anmeldenummer: PCT/DE2003/003410
(87) Internationale Veröffentlichungsnummer: WO 2004/042226

(56) Entgegenhaltungen:
- DE-A- 4 443 004
- DE-A- 19 832 826
- DE-A- 19 856 186
- DE-A- 19 940 347
- US-A- 5 059 857
- US-A- 5 244 180
- US-A- 5 476 079
- US-A- 5 645 226

## Beschreibung

Die Erfindung betrifft eine Piezoaktorkontaktierung für ein Einspritzventil eines Verbrennungsmotors, mit aus einem Piezoaktor hervorstehenden Anschlussstiften, an die eine elektrische Außenverbindung anschließbar ist, und mit einer auf den Piezoaktor und die Anschlüssstifte aufgesetzten Kopfplatte, in der Öffnungen zum Durchtritt der Anschlussstifte vorgesehen sind, wobei die Öffnungen einen größeren Durchmesser als die Anschlussstifte aufweisen, so dass zwischen jedem Anschlussstift und der Wandung der betreffenden Öffnung jeweils ein Ringspalt gebildet ist.

Eine derartige Piezoaktorkontaktierung ist bereits aus der DE 199 40 347 A1,US 5059857 A, sowie US 5645 226A bekannt.

Für die Kraftstoffversorgung von Verbrennungsmotoren werden zunehmend Hochdruck-Einspritzsysteme verwendet. Bekannt sind Pumpe-Düse-Dieseleinspritzsysteme und Speichereinspritzsysteme wie Common-Rail-Systeme (für Dieselmotoren) und HPDI-Einspritzsysteme (für Ottomotoren). Bei den Speichereinspritzsystemen wird der Kraftstoff mit einer Hochdruckpumpe in einen allen Zylindern des Motors gemeinsamen Druckspeicher gefördert, von dem aus die Einspritzventile an den einzelnen Zylindern versorgt werden. Die Steuerung des Öffnens und Schließens der Hochdruck-Einspritzventile kann elektromagnetisch oder elektrisch erfolgen; im vorliegenden Fall werden dazu elektrische Piezoaktoren herangezogen. Die Düsennadel des Einspritzventils kann vom Piezoaktor direkt oder indirekt, über ein Steuer- oder Servoventil, angesteuert werden.

Bei elektrischer Erregung über die Anschlussstifte wird in einem Piezoaktor bekanntlich eine Verformung des Aktorkörpers in Längsrichtung erzeugt; dieser Hub des Aktors wird zur Steuerung des Ventils verwertet. Da die Piezokeramik insbesondere gegen chemische Umgebungseinflüsse empfindlich ist, ist es üblich, ein Aktorgehäuse bzw. eine Kopfplatte vorzusehen, aus dem jedoch die Kontakte für die elektrische Außenverbindung des Aktors in möglichst abdichtender Weise herausführbar sein müssen.

Aus der eingangs genannten deutschen Offenlegungsschrift DE 199 40 347 A 1 ist eine elektrische Verbindungsvorrichtung zum Aufsetzen auf parallel hervorstehende Anschlussstifte eines mit einer Kopfplatte versehenen piezoelektrischen Bausteins bekannt, die einen Trägerkörper aus Isoliermaterial mit Bohrungen zum Hindurchschieben der Anschlussstifte umfasst. Eine solche Zwischenvorrichtung wird häufig benutzt, um eine Weiterkontaktierung des Piezoaktors über Steckverbinder zu ermöglichen, das heißt, sie soll den Übergang von den (für eine unmittelbare Steckverbindung wenig geeigneten) Anschlussstiften zu passenden, im Trägerkörper angeordneten, Kontaktgliedern herstellen, welche dann mit den Gegenkontaktgliedern der anderen Verbinderhälfte zusammensteckbar sind.

Da derartige Verbindungsvorrichtungen den Piezoaktor auch vor schädlichen Umgebungseinflüssen schützen sollen, wie sie im Umfeld eines Verbrennungsmotors herrschen, empfiehlt es sich, die Vorrichtung nach dem Aufbringen auf den Piezoaktor mit einer isolierenden Umspritzung aus Kunststoff zu versehen, die gleichzeitig auch ein Verbindergehäuse zum Einstecken und sicheren Sitz einer anzuschließenden Steckverbinderhälfte bildet. Beim Umspritzen können jedoch Probleme auftreten, falls die bei hoher Temperatur und hohem Druck verarbeitete Spritzmasse bis zum Piezoaktor vordringt. Um dies zu vermeiden und um für die aus dem Aktorgehäuse ausgetretenen Anschlussstifte keine separaten Dichtelemente, beispielsweise O-Ringe, an einer Durchgangsstelle im Trägerkörper - mit entsprechend erschwerter Handhabung beim Herstellen und Aufsetzen der Vorrichtung auf die Stifte - vorsehen zu müssen, schlägt die bekannte Vorrichtung kopfplattenseitig am Trägerkörper angeformte Manschetten vor, die dicht passend in den Ringspalt der jeweils zugeordneten Kopfplattenöffnung eingeführt werden.

Für zukünftige Anwendungen von piezogesteuerten Ventilen in Verbrennungsmotoren dürfte der allgemeine Schutz vor dem Eindringen von flüssigen Medien in den Raum des Piezos gegenüber den nur bei der Herstellung auftretenden Abdichtungsproblemen, wie dem Umspritz-Problem und der Verhinderung des Eindringens von Reinigungs- und Schmiermitteln während des Fertigungsprozesses, in den Vordergrund treten. Insbesondere soll zukünftig die elektrische Kontaktierung des Piezoaktors in einem Dieselmotor innerhalb des Zylinderkopfes unterhalb des Zylinderkopfdeckels angeordnet werden. Dadurch würde der Piezoaktor, bzw. sein Gehäuse und sein Stecker, im Betrieb permanent von Motoröl umspült, das im Falle des Eindringens den Piezoaktor zerstören könnte.

Es ist Aufgabe der Erfindung, bei geringem baulichen Aufwand eine auch dauerhaft und in schwieriger Umgebungssituation zuverlässige Abdichtung der Piezoaktorkontaktierung zu gewährleisten.

Diese Aufgabe wird erfindungsgemäß durch die im Patentanspruch 1 angegebenen Merkmale gelöst. Vorteilhafte Ausgestaltungen der Erfindung sind in Unteransprüchen gekennzeichnet.

Bei der erfindungsgemäßen Piezoaktorkontaktierung der eingangs genannten Art sind Dichtringe aus einem dichtenden und elektrisch isolierenden Material derart in die Durchtrittsöffnungen eingesetzt, dass ein Dichtring zwischen dem jeweiligen Anschlussstift und der Wandung der betreffenden Öffnung abdichtend zur Anlage kommt. Ferner ist in jeder Durchtrittsöffnung unterhalb des Dichtringes eine Hülse aus Isolationsmaterial eingesetzt, die eine Zentrierung des Anschlussstiftes in der Durchtrittsöffnung bewirkt.

Demnach besteht das Prinzip der Erfindung zunächst darin, als Abdichtungsstelle die Durchtrittsöffnung in der Kopfplatte zu wählen, da diese die kleinste (kürzeste) zu dichtende Stelle ist. Die Erfindung erlaubt es, einen handelsüblichen Elastomer-Dichtring (O-Ring) mit dichtenden und elektrisch isolierenden Eigenschaften zu wählen, sofern gleichzeitig das Einsetzen einer Isolationshülse unterhalb des Dichtringes zur Zentrierung und elektrischen Isolation der Anschlussstifte gegen die metallische Kopfplatte des Piezoaktor vorgesehen wird.

Die erfindungsgemäße abgedichtete Piezoaktorkontaktierung lässt sich einfach und kostengünstig herstellen, ermöglicht eine einfache Montage und bietet vor allem eine dauerhaft sichere Abdichtungsfunktion gegenüber flüssigen Medien mit hohen Drücken. Insbesondere schafft die Erfindung eine öldichte Kontaktierung für einen gehäusten Piezoaktor, bei der der zur Verfügung stehende Bauraum optimal genützt wird.

Es ist von besonderem Vorteil, wenn oberhalb der Kopfplatte ein Kunststoff-Formteil vorgesehen ist, das Bohrungen für die Anschlussstifte aufweist und das nach dem Aufsetzen auf die Anschlussstifte wenigstens teilweise formschlüssig an den Anschlussstiften und an der Kopfplatte anliegt. Dadurch wird das eigentliche Dichtelement, der Dichtring, selbst auch noch vor Beschädigungen oder Dichtungsverlust, insbesondere bei nachfolgenden Herstellungsprozessen, geschützt. Ein erheblicher Vorteil entsteht zusätzlich dadurch, dass die mechanische Stabilität der dichten Piezoaktorkontaktierung durch die zentrierende Stützwirkung des Kunststoff-Formteils weiter verbessert wird. Auch die Dichtwirkung an sich wird unterstützt, da der zwischen Kunststoff-Formteil und Isolationshülse wie in einer Dichtnut geführte Dichtring bei Druckbelastung ein optimales Verformungsverhalten entwickeln kann.

Dieses Kunststoff-Formteil kann insbesondere durch den Trägerkörper einer elektrischen Verbindungsvorrichtung zur Weiterkontaktierung der Anschlussstifte gebildet sein. Diese angepasste Gestaltung der Weiterkontaktierung übernimmt insbesondere den Schutz des unterhalb des Kunststoff-Formteils befindlichen Dichtringes gegen Beschädigung in nachfolgenden Fertigungsprozessen, beispielsweise bei einer die Herstellung abschließenden Kunststoffumspritzung.

Es ist demnach von Vorteil, dass zumindest ein Teil der Piezoaktorkontaktierung gemeinsam mit der Verbindungsvorrichtung mit einer Steckeranspritzung aus Kunststoff versehen ist, wobei das Kunststoff-Formteil der Verbindungsvorrichtung zugleich als Schutz für die Dichtringe während des Umspritzens mit Kunststoff dient.

Die Erfindung wird nachstehend an Ausführungsbeispielen anhand der Zeichnung näher erläutert. Es zeigt:
- Figur 1,: in teilweise aufgeschnittener Darstellung, eine er- findungsgemäße Piezoaktorkontaktierung mit aufge- setzter Verbindungsvorrichtung und mit Steckeran- spritzung,
- Figur 2: die Piezoaktorkontaktierung gemäß Figur 1, jedoch aus um 90° gedrehter Blickrichtung gesehen,
- Figur 3: eine Vergrößerung des in Figur 2 aufgeschnitten dar- gestellten Abdichtungsbereiches,
- Figur 4: eine andere Ausgestaltung des in Figur 3 gezeigten Abdichtungsbereiches,
- Figur 5: eine Draufsicht schräg von oben auf sechs verschiede- nen Herstellungsstadien einer erfindungsgemäßen Pie- zoaktorkontaktierung.

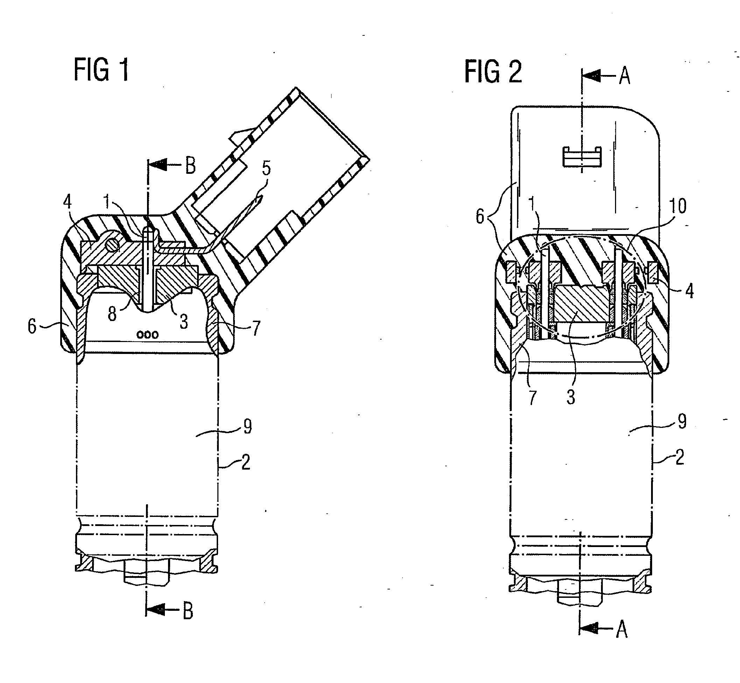

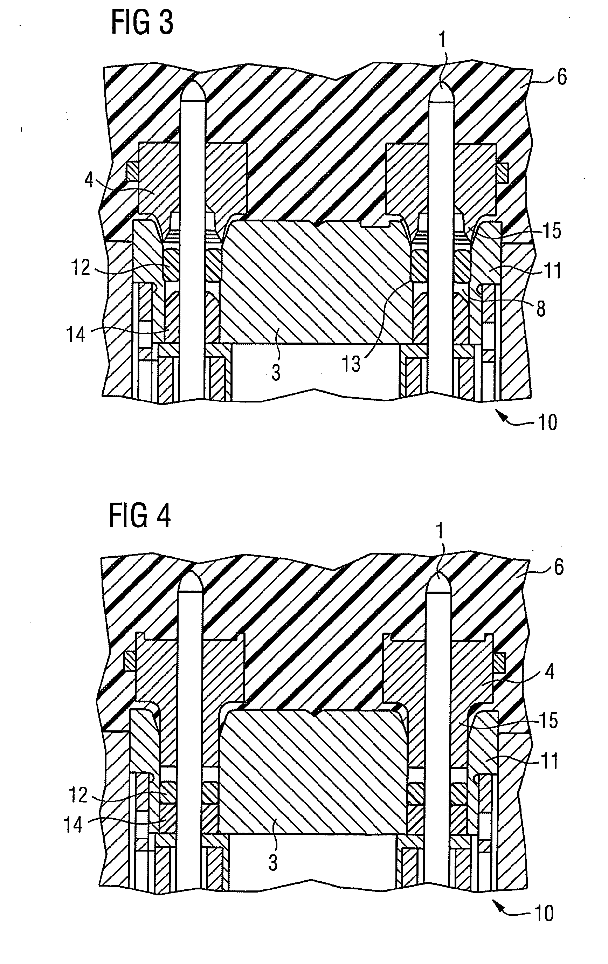

Figur 1 zeigt die erfindungsgemäße Piezoaktorkontaktierung mit den typischerweise parallel hervorstehenden Anschlussstiften 1 und einer auf die Stifte 1 und die Oberseite des Piezoaktors bzw. des Piezoaktorgehäuses 2 aufgesetzten Kopfplatte 3. Ferner dargestellt ist eine weiterkontaktierende Verbindungsvorrichtung mit einem Trägerkörper 4 aus Isoliermaterial. In den Trägerkörper 4 sind metallische, in der dargestellten Weise abgewinkelte Kontaktglieder 5 eingegossen. Die äußeren freien Enden der Kontaktglieder 5 stehen seitlich ab, sie dienen zum Aufschieben der Steckkontakte von äußeren Zuleitungen (nicht dargestellt). Die Anschlussstifte 1 werden mit dem zugehörigen Kontaktglied 5 typischerweise verschweißt. Dargestellt ist außerdem eine Steckeranspritzung 6 aus Kunststoffmaterial, die durch Umspritzen des Trägerkörpers 4 und des oberen Teils 7 des (metallischen) Piezoaktorgehäuses 2, unter Bewahrung der Zugänglichkeit der Kontaktglieder 5, zu Stande kommt. Erkennbar ist auch, das die Durchtrittsöffnungen 8 in der Kopfplatte 3 zu den durch sie durchgehenden Anschlussstiften 1 hin jeweils einen Ringspalt (besser zu erkennen in Figur 3) freilassen. Der unterhalb der Kopfplatte 3 liegende Aktorraum 9 mit dem Piezoaktor (nicht dargestellt) wird mittels des im Folgenden näher beschriebenen Abdichtungsbereiches dauerhaft gegen das Eindringen von flüssigen Medien abgedichtet.

Figur 2 zeigt einen Schnitt B-B durch die in Figur 1 dargestellte Anordnung, wobei der (in Figur 2 durch "Einkreisung" markierte) Abdichtungsbereich 10 in Figur 3 vergrößert dargestellt wird.

Figur 3 zeigt vergrößert den im Schnitt dargestellten Abdichtungsbereich 10 gemäß Figur 2. Zwischen dem zentralen Bereich und der Peripherie 11 der Kopfplatte 3 sind zwei Durchtrittsöffnungen 8, jeweils mit einem hindurchgeführten Anschlussstift 1, dargestellt. Im oberen Bereich der Öffnungen 8 ist jeweils ein kraftstoffbeständiger Elastomer-Dichtring 12 erkennbar. Die Öffnungen 8 in der Kopfplatte 3 können durchgehend oder mit einer Stufe 13 ausgeführt sein. Dieses ist abhängig von der Größe der einzusetzenden Dichtringe. Die in Figur 3, rechts, beispielhalber dargestellte rechte Durchtrittsöffnung 8 hat auf Grund der Stufe 13 im oberen Bereich eine größere Weite als im unteren Bereich. Dies ist zum einen deshalb vorteilhaft, da derartige Dichtringe mit zunehmenden Durchmesser eine bessere Dichtwirkung aufweisen. Zum anderen besteht eine Stützwirkung der Stufe 13 auf den Dichtring 12.

Unterhalb der O-Ringe 12 ist jeweils eine Isolationshülse 14 aus Kunststoff (typischerweise ein Spritzgussteil) eingesetzt, die eine Zentrierung des Anschlussstiftes 1 in der Öffnung 8 der Kopfplatte 3 übernimmt. Dies ist erforderlich, da insbesondere die Weite der Öffnung 8 und der Durchmesser der Stifte 1 toleranzbehaftet sind und die elastisch nachgebenden Dichtringe 12 allein eine beispielsweise durch die Toleranzen bedingte Verkippung der Stifte 1 nicht verhindern könnten. Gleichzeitig stellt die Isolationshülse 14 die untere Begrenzung einer "Dichtringnut" dar, in der sich das elastische Material des Dichtringes 12 bei Belastung in abdichtender Weise anpassen kann.

Oberhalb des Dichtrings 12 übernimmt vorteilhaft ein Kunststoff-Formteil 4 der Weiterkontaktierung die Zentrierung des Stifts 1. Dieses Formteil 4 ist dabei so ausgestaltet, dass es am jeweiligen Stift 1 und teilweise auch an der Oberseite und/oder in der Öffnung 8 der Kopfplatte 3 formschlüssig anliegt, wodurch es neben der Zentrierungswirkung gleichzeitig den jeweils darunter befindlichen Dichtring 12 gegen eine Beschädigung oder Dichtungsverlust bei nachfolgenden Herstellungsprozessen schützt, beispielsweise bei einer finalen Kunststoffumspritzung des gesamten Bauteils. Die Formteile 4 für die verschiedenen Öffnungen 8 werden typischerweise einstückig miteinander zusammenhängend, insbesondere den Trägerkörper 4 der Weiterkontaktierung bildend, ausgeführt.

In Figur 3 erkennbar ist ferner ein vorstehender, am kopfplattenseitigen Rand der Bohrungen des Formteils 4 angeformter kleiner Ansatz 15, der beim Aufsetzen auf die Anschlussstifte 1 im oberen Bereich der jeweiligen Durchtrittsöffnung 8 der Kopfplatte 3, einen Dichtspalt bildend, zur Anlage kommt. Dieser Ansatz 15 ist in der Ausführung gemäß Figur 4 stärker betont; aufgrund der größeren Länge des Ansatzes 15 rücken in der Durchtrittsöffnung 8 der Dichtring 12 und die Isolationshülse 14 dann, wie dargestellt, entsprechend näher zusammen.

Des Weiteren bildet das Formteil 4 die obere Begrenzung der "Dichtringnut". Durch den Einsatz von Isolationshülse 14 und Formteil 4 der Weiterkontaktierung erzielt man in Bauraum einsparender Weise eine "gebaute Dichtringnut". Durch den beschriebenen Aufbau ist gewährleistet, dass bei einer fertig hergestellten Piezoaktorkontaktierung trotz Außenverbindung der Kontakte kein flüssiges Medium, insbesondere kein Motoröl, in den Piezoraum 9 unterhalb der Kopfplatte 3 eindringen kann. Auch bei mechanischen Belastungen wie Motorvibrationen kann durch die doppelte Zentrierung der Stifte 1 und die mittig gelagerten Dichtringe die Stabilität der Piezoaktorkontaktierung aufrechterhalten werden, so dass keine Kurzschlüsse bzw. Undichtigkeiten im Zusammenhang mit der Durchführung der Stifte 1 auftreten.

Der Piezoaktor kann im übrigen ohne weiteres auch mehr als zwei Kontakte bzw. Anschlussstifte 1 aufweisen.

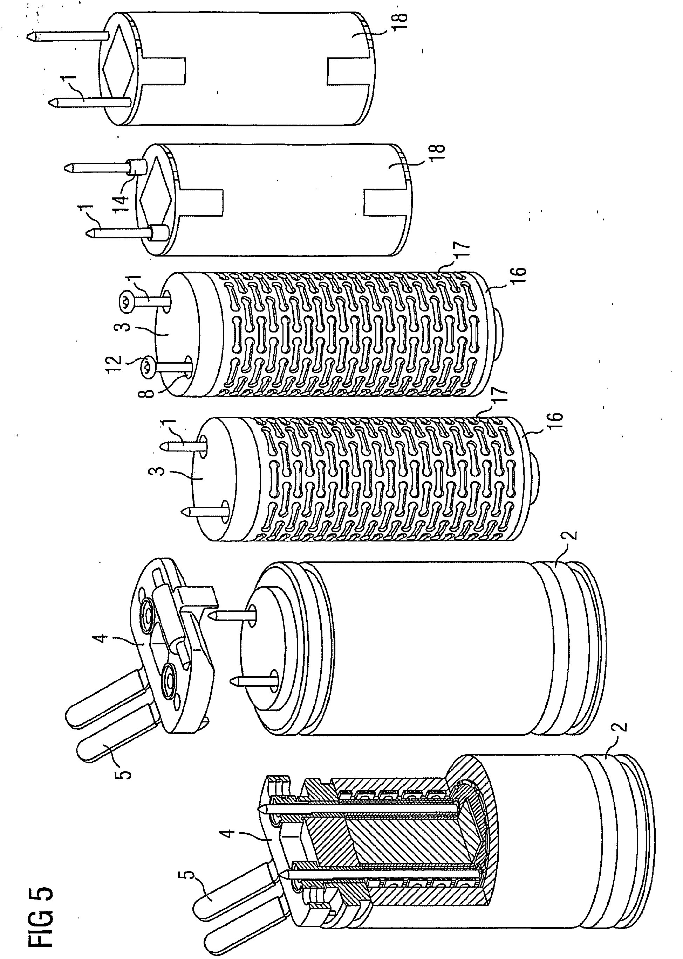

Figur 5 zeigt die aufeinanderfolgenden Stadien der Herstellung des gesamten Aufbaus der Piezoaktorkontaktierung im Überblick. Wenn über die Anschlussstifte 1 eine Steuerspannung an den Piezoaktor 18 angelegt wird, reagiert dieser mit einer Längung des Aktorkörpers; dieser Hub kann z. B. über eine Fußplatte 16 des Aktors 18 mechanisch bzw. hydraulisch weitergeleitet werden. Der Piezoaktor 18, üblicherweise als Vielschicht-Piezostack ausgeführt, wird in eine Rohrfeder 17 eingebracht, die mit der Fußplatte 16 verschweißt wird. Die Rohrfeder 17 ist mit der Kopfplatte 3 so verbunden, dass sie unter einer gewissen Vorspannung steht, welche als Rückstellkraft für den Piezoaktor 18 wirkt.

Zur Montage der Piezoaktorkontaktierung wird zunächst, wie in Figur 5, ganz rechts, erkennbar, ein ungehäuster, mit zwei Anschlussstiften 1 versehener Piezoaktor 18 bereitgestellt. Im nächsten Schritt, vgl. das zweite Bild von rechts, wird eine Isolationshülse 14 mit gleitender Passung auf jeden der Stifte 1 aufgesteckt. Anschließend werden die mit der Isolationshülse 14 versehenen Stifte 1 durch eine Kopfplatte 3 hindurchgeführt und der Piezoaktor 18 wird zwischen der Kopfplatte 3 und einer Fußplatte 16 mittels einer Rohrfeder 17 verspannt. Das dritte Bild von rechts zeigt, wie die Dichtringe 12 von oben auf die Stifte 1 der so weit vorbereiteten Piezoaktorkontaktierung aufgesetzt werden. Das vierte Bild von rechts zeigt dann bereits das Fertigungsstadium, in welchem die Dichtringe 12 von oben her in die jeweilige Öffnung 8 der Kopfplatte 3 bis in eine Position oberhalb der zugehörigen Isolationshülse 14, jedoch innerhalb der Kopfplatte 3, fertig eingeschoben sind.

Das fünfte Bild von rechts in Figur 5 zeigt eine in ein Gehäuse 2 eingesetzte Piezoaktorkontaktierung zusammen mit einer noch nicht auf die Stifte 1 aufgesetzten Verbindungsvorrichtung mit dem Trägerkörper 4. Das erste Bild von links in Figur 5 zeigt die fertige Piezoaktorkontaktierung mit aufgesetztem Trägerkörper 4 der Weiterkontaktierung, wobei der obere Teil des gesamten Aufbaus in einer perspektivisch aufgeschnitten Darstellung gezeigt ist.

## Patentansprüche

1. Piezoaktorkontaktierung für ein Einspritzventil eines Verbrennungsmotors, mit aus einem Piezoaktor (18) hervorstehenden Anschlussstiften (1), an die eine elektrische Außenverbindung anschließbar ist, und mit einer auf den Piezoaktor (18) und die Anschlussstifte (1) aufgesetzten Kopfplatte (3), in der Öffnungen (8) zum Durchtritt der Anschlussstifte (1) vorgesehen sind, wobei die Öffnungen (8) einen größeren Durchmesser als die Anschlussstifte (1) aufweisen, so dass zwischen jedem Anschlussstift (1) und der Wandung der betreffenden Öffnung (8) jeweils ein Ringspalt gebildet ist, **dadurch gekennzeichnet,**
- **dass** Dichtringe (12) aus einem dichtenden und elektrisch isolierenden Material derart in die Öffnungen (8) eingesetzt sind, dass ein Dichtring (12) zwischen dem jeweiligen Anschlussstift (1) und der Wandung der betreffenden Öffnung (8) abdichtend zur Anlage klmmt,
- und **dass** in einer Öffnung (8) unterhalb des Dichtringes (12) eine Hülse (14) aus Isolationsmaterial eingesetzt ist, die eine Zentrierung des Anschlussstiftes (1) in der Durchtrittsöffnung (8) bewirkt.

2. Piezoaktorkontaktierung nach Anspruch 1,
**dadurch gekennzeichnet, dass** oberhalb der Kopfplatte (3) ein Kunststoff-Formteil (4) vorgesehen ist, das Bohrungen für die Anschlussstifte (1) aufweist und das nach dem Aufsetzen auf die Anschlussstifte (1) wenigstens teilweise formschlüssig an den Anschlussstiften (1) und an der Kopfplatte (3) anliegt.

3. Piezoaktorkontaktierung nach Anspruch 2,
**dadurch gekennzeichnet, dass** am kopfplattenseitigen Rand der Bohrung des Kunststoff-Formteils (4) jeweils ein vorstehender Ansatz (15) angeformt ist, der beim Aufsetzen auf die Anschlussstifte (1) im oberen Bereich der jeweiligen Durchtrittsöffnungen (8) der Kopfplatte (3), einen Dichtspalt bildend, zur Anlage kommt.

4. Piezoaktorkontaktierung nach Anspruch 2 oder 3,
**dadurch gekennzeichnet, dass** das Kunststoff-Formteil (4) durch den Trägerkörper einer elektrischen Verbindungsvorrichtung zur Weiterkontaktierung der Anschlussstifte (1) gebildet ist.

5. Piezoaktorkontaktierung nach Anspruch 4,
**dadurch gekennzeichnet, dass** zumindest ein Teil der Piezoaktorkontaktierung gemeinsam mit der Verbindungsvorrichtung mit einer Steckeranspritzung (6) aus Kunststoff versehen ist, wobei das Kunststoff-Formteil (4) der Verbindungsvorrichtung zugleich als Schutz für die Dichtringe (12) während des Umspritzens mit Kunststoff dient.

## Claims

1. Piezo-electric actuator contact for an injection valve of a internal combustion engine, with terminal pins (1) projecting from a piezo-electric actuator (18), to which an electrical external connection can be linked, and with a head plate (3) placed on the piezo-electric actuator (18) and the terminal pins (1), in which are provided openings (8) for passage of the terminal pins (1), where the openings (8) have a greater diameter than the terminal pins (1), so that an annular gap is in each case formed between each terminal pin (1) and the wall of the respective opening (8),
**characterised in that,**
- sealing rings (12) made of a sealant and electrically insulating material are inserted into the openings (8) in such a way that a sealing ring (12) comes to rest between the respective terminal pin (1) and the wall of the opening concerned (8), forming a seal,
- and that a bushing (14) made of an insulating material is inserted into an opening (8) beneath the sealing ring (12), said bushing (14) centring the terminal pins (1) in the passage opening (8).

2. Piezo-electric actuator contact according to claim 1, **characterised in that** a moulded plastic component (4) is provided above the head plate (3), said component having holes for the terminal pins (1), and after placement on the terminal pins (1) resting on the terminal pins (1) and the head plate (3) at least partially in a form-fitted manner.

3. Piezo-electric actuator contact according to claim 2, **characterised in that** in each case a projecting lug (15) is formed on the edge of the hole in the moulded plastic component (4) on the head plate side, which upon placement on the terminal pins (1) comes to rest in the upper area of the respective passage holes (8) of the head plate (3), forming a sealing gap.

4. Piezo-electric actuator contact according to claim 2 or 3, **characterised in that** the moulded plastic component (4) is formed by the carrier body of an electrical connection device for further contacting of the terminal pins (1).

5. Piezo-electric actuator contact according to claim 4, **characterised in that** at least part of the piezo-electric actuator contact together with the connection device is provided with a connector injection (6) made of plastic, where the moulded plastic component (4) of the connection device serves at the same time as protection for the sealing ring (12) during the coating with plastic.

## Revendications

1. Contact d'actionneur piézoélectrique pour une soupape d'injection d'un moteur à combustion interne, comportant des plots de connexion (1), qui s'avancent en saillie hors d'un actionneur piézoélectrique (18) et auxquels peut être raccordée une liaison électrique extérieure et comportant une plaque supérieure (3), qui est posée sur l'actionneur piézoélectrique (18) et les plots de connexion (1) et dans laquelle sont prévus des orifices (8) pour le passage des plots de connexion (1), lesdits orifices (8) ayant un diamètre supérieur à celui des plots de connexion (1), de telle sorte qu'il se forme respectivement un espace annulaire entre chaque plot de connexion (1) et la paroi de l'orifice (8) concerné, **caractérisé**
- **en ce que** des bagues d'étanchéité (12), réalisées dans un matériau étanche et électro-isolant, sont insérées dans les orifices (8) de telle sorte qu'une bague d'étanchéité (12) vient en appui étanche entre le plot de connexion (1) respectif et la paroi de l'orifice (8) concerné,
- et **en ce qu'**un manchon (14) en matériau isolant est enfiché dans un orifice (8) en dessous de la bague d'étanchéité (12), lequel manchon induit le centrage du plot de connexion (1) dans l'orifice de passage (8).

2. Contact d'actionneur piézoélectrique selon la revendication 1, **caractérisé en ce qu'**il est prévu, au-dessus de la plaque supérieure (3), un élément moulé (4) en matière plastique, qui comporte des forures pour les plots de connexion (1) et qui, après la pose sur les plots de connexion (1), est en appui au moins en partie par conjugaison de forme contre les plots de connexion (1) et contre la plaque supérieure (3).

3. Contact d'actionneur piézoélectrique selon la revendication 2, **caractérisé en ce que** sur le bord, du côté de la plaque supérieure, de la forure de l'élément moulé (4) en matière plastique est formé respectivement un appendice (15) saillant qui, au moment de la pose sur les plots de connexion (1), vient en appui en formant un espace étanche dans la zone supérieure des orifices de passage (8) respectifs de la plaque supérieure (3).

4. Contact d'actionneur piézoélectrique selon la revendication 2 ou 3, **caractérisé en ce que** l'élément moulé (4) en matière plastique est formé par le corps de support d'un dispositif de liaison électrique pour une mise en contact des plots de connexion (1).

5. Contact d'actionneur piézoélectrique selon la revendication 4, **caractérisé en ce qu'**au moins une partie du contact d'actionneur piézoélectrique, conjointement avec le dispositif de liaison, est munie d'un moulage par injection formant un connecteur (6) en matière plastique, l'élément moulé (4) en matière plastique du dispositif de liaison assurant en même temps la fonction de protection pour les bagues d'étanchéité (12) pendant l'enrobage avec la matière plastique.
